# EUROPEAN PATENT SPECIFICATION

(11) **EP 2 070 601 B1**
(45) Date of publication and mention of the grant of the patent: **02.05.2012**
(21) Application number: 08170636.8
(22) Date of filing: 04.12.2008
(51) Int. Cl.: B05D 7/24

(54) **Low dielectric constant plasma polymerized thin film and manufacturing method thereof**
Niederdielektrischer konstanter plasmapolymerisierter Dünnfilm und Herstellungsverfahren dafür
Film à couche mince polymérisé à plasma constant faiblement diélectrique et son procédé de fabrication

(30) Priority: 06.12.2007 KR 20070126331
(43) Date of publication of application: 17.06.2009
(73) Proprietor: Sungkyunkwan University Foundation for Corporate Collaboration, Jangan-gu, Suwon Kyonggi do 440-746 (KR)
(72) Inventor: Jung, Donggeun, Seoul 135-270 (KR); Lee, Sungwoo, Gyeonggi-do 440-320 (KR); Woo, Jihyung, Gyeonggi-do 437-070 (KR)
(74) Representative: Cabinet Plasseraud

(56) References cited:
- EP-A- 1 482 070
- EP-A- 1 820 881
- WO-A-2004/083495
- WO-A-2008/117905
- US-A1- 2006 079 099
- US-A1- 2007 077 353

## Description

### BACKGROUND OF THE INVENTION

### 1. Field of the Invention

The present invention relates in general to a low dielectric constant plasma polymerized thin film and a manufacturing method thereof, and more particularly, to a plasma polymerized thin film for use in semiconductor devices, which has a low dielectric constant and shows improved insulating property and is also improved in terms of mechanical properties including hardness and elastic modulus, and to a method of manufacturing the same.

### 2. Description of the Related Art

Presently, one of the chief steps in the fabrication of a semiconductor apparatus is the formation of metal and dielectric thin films on a substrate through the chemical reaction of gases. This deposition process is referred to as chemical vapor deposition (CVD). Typically, in a thermal CVD process, reactant gases are supplied to the surface of a substrate, so that a thermally-induced chemical reaction occurs on the surface of the substrate, thus forming a thin film of a predetermined thickness. Such a thermal CVD process is conducted at high temperatures, which may thus damage device geometries in which layers are formed on the substrate. A preferred example of a method of depositing metal and dielectric thin films at relatively low temperatures includes plasma-enhanced CVD (PECVD) disclosed in US Patent No. 5,362,526, entitled "Plasma-enhanced CVD process using TEOS for depositing silicon oxide", which is hereby incorporated by reference into this application.

WO2004/083495 discloses a method for forming a multiphase, low dielectric constant plasma polymerized thin film.

According to PECVD, radio frequency (RF) energy is applied to a reaction zone, thus promoting the excitation and/or dissociation of reactant gases, thereby creating plasma of highly reactive species. High reactivity of the released species reduces the energy required for a chemical reaction to take place and thus lowers the required temperature for such PECVD. Thus, semiconductor device geometries have dramatically decreased in size due to the introduction of such an apparatus and method.

Further, in order to decrease the RC delay of the multilayered metal film used for integrated circuits of a ULSI semiconductor device, thorough research into preparation of interlayer insulating films used for metal wires using material having a low dielectric constant (k ≤ 3.0) is being conducted these days. Such a low dielectric constant thin film is formed of an organic material or an inorganic material such as a fluorine (F)-doped oxide film (SiO₂) and a fluorine-doped amorphous carbon film (a-C:F). Polymerized thin films having a relatively low dielectric constant and relatively superior thermal stability are used mainly as an organic material.

Very useful to date are interlayer insulating films of silicon dioxide (SiO₂) or silicon oxyfluoride (SiOF), which have some defects, such as high capacitance and long RC delay time, upon fabrication of ultra-highly integrated circuits of 0.5 µm or less, and thus intensive research into substituting for it a novel low dielectric constant material is being conducted recently, but satisfactory solutions have not yet been proposed.

Examples of the low dielectric constant material presently usable instead of SiO₂ include organic polymers for spin coating, such as BCB (benzocyclobutene), SILK (available from DOW Chemical), FLARE (fluorinated poly(arylene ether), available from Allied Signals), and polyimide, materials for CVD, such as Black Diamond (available from Applied Materials), Coral (available from Novellus), SiOF, alkyl silane, and parylene, and porous thin film materials, such as xerogel or aerogel.

Most polymerized thin films are formed through spin casting by which a polymer is chemically synthesized, applied on a substrate through spin coating, and then cured. The low dielectric constant thin film thus formed advantageously has a low dielectric constant because the pores having a size of single-digits of nanometers are formed in the thin film, thus lowering the density of the thin film. The organic polymers which are typically deposited through spin coating have a low dielectric constant and superior planarization, but have poor thermal stability due to low heat-resistant threshold temperatures below 450°C and are thus inadequate in terms of availability. Further, the above organic polymers are disadvantageous because the pores are non-uniformly distributed in the film owing to a large size thereof, thus causing many problems upon the manufacture of devices. Furthermore, the above organic polymers are problematic in that they come into poor contact with upper and lower wiring materials, that thin films resulting therefrom intrinsically incur high stress upon thermal curing, and also that the dielectric constant thereof varies attributable to water absorption, undesirably decreasing the reliability of the device.

### SUMMARY OF THE INVENTION

Leading to the present invention, thorough research into methods of manufacturing thin films having a very low dielectric constant, carried out by the present inventors aiming to solve the problems encountered in the related art, resulted in the finding that, when a plasma polymerized thin film is formed through PECVD using linear organic/inorganic precursors, pores having a size of nanometers or smaller may be formed, problems arising in spin casting including a complicated process and a long process time for pretreatment and post-treatment may be overcome, and the dielectric constant and mechanical properties of thin films may be improved through annealing.

Therefore, the present invention provides a low dielectric constant plasma polymerized thin film which is improved in terms of dielectric constant, mechanical properties and the insulating property and also provides a method of manufacturing the same.

According to an aspect of the present invention, a low dielectric constant plasma polymerized thin film may be manufactured using precursors represented by Formulas 1 and 2 below. 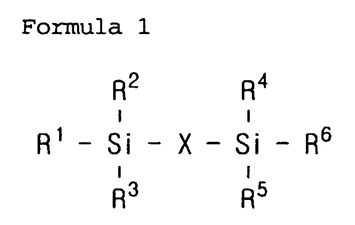 wherein R¹ to R⁶ are each independently selected from the group consisting of a hydrogen atom and substituted or unsubstituted C₁₋₅ alkyl groups, and X is an oxygen atom or a C₁₋₅ alkylene group. 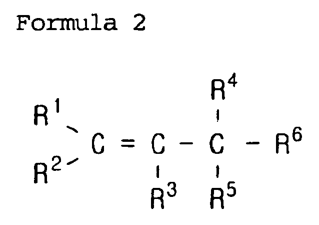 wherein R¹ to R⁵ are each independently selected from the group consisting of a hydrogen atom; and substituted or unsubstituted C₁₋₅ alkyl groups, and R⁶ is selected from the group consisting of a hydrogen atom; and substituted or unsubstituted C₁₋₅ alkyl groups and alkoxysilane groups. R⁶ of Formula 2 may represent -O-Si(R⁷)₃; and wherein R⁷ may be selected from the group consisting of C₁₋₆ alkyl groups and phenyl groups.

The low dielectric constant polymerized thin film may be manufactured using PECVD.

The precursor represented by Formula 1 may be hexamethyldisiloxane, and the precursor represented by Formula 2 may be 3,3-dimethyl-1-butene or allyloxytrimethylsilane.

In addition, according to another aspect of the present invention, a method of manufacturing a low dielectric constant plasma polymerized thin film may comprise depositing a plasma polymerized thin film on a substrate using precursors represented by Formulas 1 and 2 below through PECVD, and annealing the deposited thin film using an RTA apparatus. 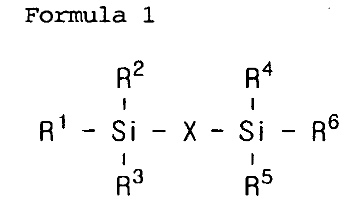 wherein R¹ to R⁶ are each independently selected from the group consisting of a hydrogen atom and substituted or unsubstituted C₁₋₅ alkyl groups, and X is an oxygen atom or a C₁₋₅ alkylene group. 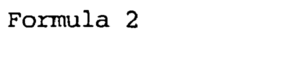 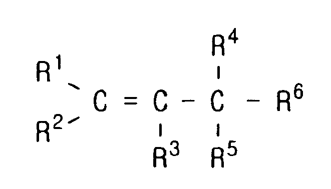 wherein R¹ to R⁵ are each independently selected from the group consisting of a hydrogen atom; and substituted or unsubstituted C₁₋₅ alkyl groups, and R⁶ is selected from the group consisting of a hydrogen atom; and substituted or unsubstituted C₁₋₅ alkyl groups and alkoxysilane groups. R⁶ of Formula 2 may represent -O-Si(R⁷)₃; and wherein R⁷ may be selected from the group consisting of C₁₋₆ alkyl groups and phenyl groups.

As such, the precursor represented by Formula 1 may be hexamethyldisiloxane, and the precursor represented by Formula 2 may be 3,3-dimethyl-1-butene or allyloxytrimethylsilane.

In the method according to the present invention, depositing the plasma polymerized thin film on the substrate may comprise vaporizing the precursors represented by Formulas 1 and 2 in bubblers, supplying the gaseous precursors into a reactor for plasma deposition from the bubblers, and forming a plasma polymerized thin film on the substrate in the reactor using plasma of the reactor.

The supplying the gaseous precursors into a reactor for plasma deposition from the bubblers may include a carrier gas of the reactor, and the carrier gas is argon(Ar) or helium(He); and wherein a pressure of the carrier gas is 1×10⁻¹ ∼ 100×10⁻¹ Torr. Also, the temperature of the substrate may be 20 ∼ 50°C, and power supplied to the reactor may be 15 ∼ 80 W.

The method further may include an annealing treatment or a plasma treatment on the plasma polymerized thin film after the forming a plasma polymerized thin film on the substrate in the reactor.

The carrier gas of the reactor, as a plasma gas, in the additional plasma treatment, may be selected from the group consisting of argon(Ar), helium (He) and a mixture gas of hydrogen and helium; and a pressure of the carrier gas may be 1×10⁻³ ∼ 1×10⁻¹ Torr. Also, the mixture gas of hydrogen and helium may consist of about 5 to 15 volume% of hydrogen gas and about 95 to 85 volume% of helium gas.

In the method according to the present invention, annealing the deposited thin film using the RTA apparatus may be conducted by placing the substrate having the plasma polymerized thin film deposited thereon in a chamber of the RTA apparatus, and generating heat on the substrate using a plurality of halogen lamps disposed around the chamber.

Also, annealing the deposited thin film using the RTA apparatus may be conducted in nitrogen gas. Tn the method according to the present invention, annealing the deposited thin film using the RTA apparatus may be conducted by increasing the temperature of the substrate to 300 ∼ 600°C and then performing annealing, and preferably by increasing the temperature of the substrate to 300 ∼ 600°C within 5 min and then performing annealing for 1 - 5 min.

Further, annealing the deposited thin film using the RTA apparatus may be conducted at a pressure of 0.5 - 1.5 Torr.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a view for schematically showing a PECVD and plasma treatment apparatus used for manufacturing a low dielectric constant plasma polymerized thin film according to the present invention;
FIG. 2 is a view for schematically showing an RTA (Rapid Thermal Annealing) apparatus used for manufacturing the low dielectric constant plasma polymerized thin film according to Example 1 of the present invention;
FIG. 3 is a graph showing the deposition rate of the low dielectric constant plasma polymerized thin film manufactured according to Example 1 of the present invention;
FIG. 4 is a graph showing the thermal stability of the low dielectric constant plasma polymerized thin film manufactured according to Example 1 of the present invention;
FIG. 5 is a graph showing the dielectric constant of the low dielectric constant plasma polymerized thin film manufactured according to Example 1 of the present invention;
FIGS. 6A and 6B are graphs showing the chemical structures of the low dielectric constant plasma polymerized thin film of Example 1 before and after heat treatment, obtained through Fourier transform infrared spectroscopy;
FIGS. 7A and 7B are graphs showing the chemical structures of hydrocarbon-based bonds of the low dielectric constant plasma polymerized thin film of Example 1 before and after heat treatment, obtained through Fourier transform infrared spectroscopy;
FIGS. 8A and 8B are graphs showing the chemical structures of silicon-oxygen-based bonds of the low dielectric constant plasma polymerized thin film of Example 1 before and after heat treatment, obtained through Fourier transform infrared spectroscopy;
FIG. 9 is a graph showing the hardness of the low dielectric constant plasma polymerized thin film manufactured according to Example 1 of the present invention;
FIG. 10 is a graph showing the elastic modulus of the low dielectric constant plasma polymerized thin film manufactured according to Example 1 of the present invention.
FIG. 11 is a graph showing the deposition rate of the low dielectric constant plasma polymerized thin film according to Example 2 in accordance with the deposition plasma power;
FIG. 12 is a graph showing the dielectric constant of the low dielectric constant plasma polymerized thin film according to Example 2 in accordance with the deposition plasma power;
FIG. 13 is a graph showing I(current)-V(voltage) of the low dielectric constant plasma polymerized thin film according to Example 3 in accordance with plasma treatment time; and
FIG. 14 is a graph showing I(current)-V(voltage) of the low dielectric constant plasma polymerized thin film according to Example 4 in accordance with plasma treatment time.

### DESCRIPTION OF THE PREFERRED EMBODIMENTS

According to the present invention, a low dielectric constant plasma polymerized thin film is manufactured using precursors represented by Formulas 1 and 2 below. 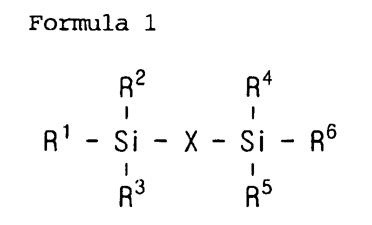 wherein R¹ to R⁶ are each independently selected from the group consisting of a hydrogen atom and substituted or unsubstituted C₁₋₅ alkyl groups, and X is an oxygen atom or a C₁₋₅ alkylene group. 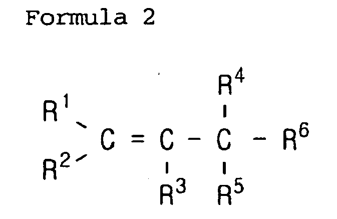 wherein R¹ to R⁵ are each independently selected from the group consisting of a hydrogen atom; and substituted or unsubstituted C₁₋₅ alkyl groups, and R⁶ is selected from the group consisting of a hydrogen atom; and substituted or unsubstituted C₁₋₅ alkyl groups and alkoxysilane groups.

In Formula 1, the alkyl group has 1 ∼ 5 carbon atoms and examples thereof include a methyl group, an ethyl group, a propyl group, and a butyl group. The alkyl group may be linear or branched, and one or more hydrogen atoms thereof may be substituted with a substituent such as a fluorine atom. Further, in Formula 1, X which is a linker may be an oxygen atom (-O-) or a C₁₋₅ alkylene group such as a methylene group or an ethylene group. Particularly useful is an oxygen atom (-O-).'

Also in Formula 2, the alkyl group has 1 ∼ 5 carbon atoms and examples thereof include a methyl group, an ethyl group, a propyl group, and a butyl group, as in Formula 1. The alkyl group may be linear or branched, and one or more hydrogen atoms thereof may be substituted with a substituent such as a fluorine atom. In case of R⁶ of Formula 2 is alkoxysilane groups, R⁶ may represent -O-Si(R⁷)₃; and R⁷ may be selected from the group consisting of C_{1∼6} alkyl groups and phenyl groups. In particular, for condensation and/or hydrolysis with the precursor of Formula 1, it is preferred that R¹ to R³ be a hydrogen atom.

In the present invention, an example of the precursor represented by Formula 1 includes hexamethyldisiloxane represented by Formula 3 below. Also, it can be considered as one of examples that the precursor of Formula 2 is formed to include, 3-dimethyl-1-butene (neohexene) represented by Formula 4 below or allyloxytrimethylsilane by Formula 5 below.

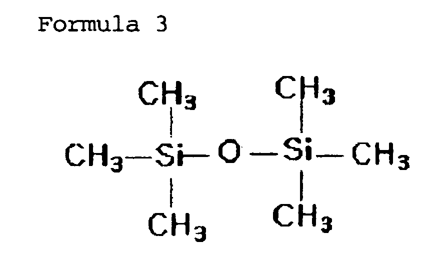

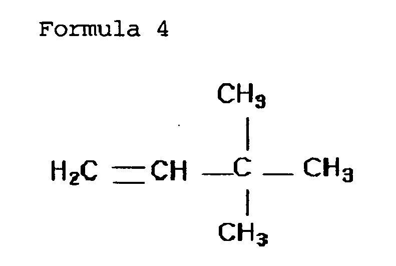

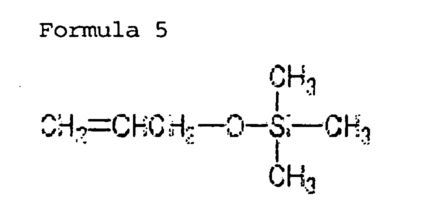

The linear organic/inorganic precursors of Formulas 1 and 2 may be used in combinations thereof, such that pores having a size of nanometers or smaller are formed in the polymerized thin film. Further, the dielectric constant is remarkably decreased, and as well, mechanical properties including hardness and elastic modulus may be increased.

The low dielectric constant plasma polymerized thin film is preferably manufactured using PECVD, in order to reduce the complicated process and long process time for pretreatment and post-treatment arising in a spin casting process.

In addition, the present invention provides a method of manufacturing the low dielectric constant plasma polymerized thin film using PECVD, including depositing a plasma polymerized thin film on a substrate using the precursors of Formulas 1 and 2 and annealing the deposited thin film using an RTA apparatus.

In the method of the present invention, depositing the plasma polymerized thin film on the substrate includes vaporizing the precursors of Formulas 1 and 2 in bubblers, supplying the gaseous precursors into a reactor for plasma deposition from the bubblers, and forming a plasma polymerized thin film on a substrate in the reactor using plasma of the reactor.

In the supplying the gaseous precursors into a reactor for plasma deposition from the bubblers, a carrier gas of the reactor may use argon(Ar) or helium(He); and a pressure of the carrier gas may be 1×10⁻¹ ∼ 100×10⁻¹ Torr. If the pressure of the carrier gas falls outside of the above range, the deposition rate may be lowered.

The method further may include an annealing treatment or a plasma treatment on the plasma polymerized thin film after the forming a plasma polymerized thin film on the substrate in the reactor. Additional process of the annealing treatment or the plasma treatment may make improvements to the properties of the thin film. The annealing treatment may be conducted that the plasma polymerized thin film is annealed to 300 - 600°C, for 30 min to 4hr. The plasma treatment may be conducted that the substrate coated with the plasma polymerized thin film is loaded in the reactor followed by the plasma treatment using the carrier gas at appropriate pressure.

In the additional plasma treatment, a plasma gas that is a carrier gas of the reactor may be selected from the group consisting of argon(Ar), helium(He) and a mixture gas of hydrogen and helium. The pressure of the carrier gas may be 1×10⁻³ ∼ 1×10⁻¹ Torr. If the pressure of the carrier gas falls outside of the above range, the insulating property of the thin film may be deteriorated.

The mixture gas of hydrogen and helium may consist of about 5 to 15 volume% of hydrogen gas and about 95 to 85 volume% of helium gas. If the volume of hydrogen is less then than 5 volume%, there may be an effect caused by He gas, but there may be little effect caused by added hydrogen gas. On the other hand, if the volume of hydrogen exceeds 15 volume%, there may be modification in the structure of the thin film.

A PECVD apparatus for performing the PECVD process includes a reactor which is a process chamber composed of an upper chamber lid and a lower chamber body, for performing the thin film deposition process. The reactant gases are uniformly sprayed onto a substrate placed on the upper surface of a susceptor formed in the chamber body via shower heads provided in the chamber lid, thus depositing the thin film. This reaction is activated by RF energy which is supplied through an electrode mounted in the susceptor, such that the thin film deposition process is carried out. The thin film thus deposited is placed on the susceptor of the RTA apparatus as an annealing apparatus, after which the annealing process is rapidly conducted at predetermined temperatures.

Below, a detailed description will be given of a low dielectric constant plasma polymerized thin film and a manufacturing method thereof according to the present invention, with reference to the appended drawings.

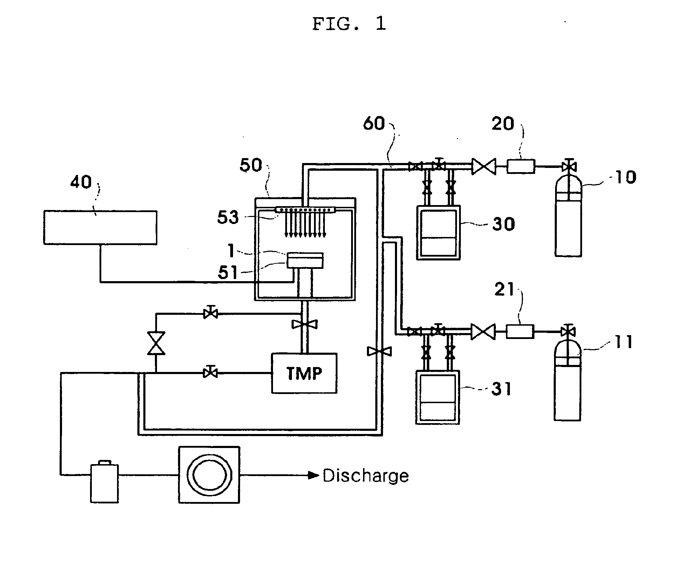

FIG. 1 shows the PECVD apparatus used for manufacturing the low dielectric constant plasma polymerized thin film according to the present invention.

An example of the PECVD apparatus includes, but is not limited to, an electric condenser type PECVD apparatus. Alternatively, other kinds of PECVD apparatus may be used.

The PECVD apparatus includes first and second carrier gas storing portions 10, 11 containing a carrier gas such as Ar, first and second flow rate controllers 20, 21 for controlling the number of moles of gases passing therethrough, first and second bubblers 30, 31 containing solid or liquid precursors, a reactor 50 in which the reaction occurs, and a RF generator 40 for generating plasma in the reactor 50. The carrier gas storing portions 10, 11, the flow rate controllers 20, 21, the bubblers 30, 31, and the reactor 50 are connected through a pipeline 60. In the reactor 50, a susceptor 51 connected to the RF generator 40 for generating plasma and for supporting the substrate 1 thereon is provided. Further, a heater (not shown) is embedded in the susceptor 51, so that the substrate 1 placed on the susceptor 51 is heated to a temperature appropriate for deposition in the course of thin film deposition. Further, an exhaust system is provided under the reactor 50 so as to discharge the reactant gases remaining in the reactor 50 after the completion of the deposition reaction.

According to the embodiment of the present invention, the method of depositing the thin film using the PECVD apparatus is described below.

A substrate 1 made of silicon (P⁺⁺-Si) doped with boron having metallic properties is washed with trichloroethylene, acetone, or methanol, and is then placed on the susceptor 51 of the reactor 50.

The first and second bubblers 30, 31 respectively contain precursors of Formulas 1 and 2, and the first and second bubblers 30, 31 are heated to temperatures adequate for the vaporization of the respective precursors. As such, it should be noted that the two types of precursors be respectively loaded into the two bubblers 30, 31, without discrimination of the bubblers, and the heating temperature of the bubblers be controlled depending on the types of precursors respectively loaded therein.

In the first and second carrier gas storing portions 10, 11, a carrier gas, selected from among argon (Ar) or helium (He), is loaded and flows via the pipeline 60 by means of the first and second flow rate controllers 20, 21. The carrier gas flowing along the pipeline 60 is introduced into the precursor solutions of the bubblers 30, 31 via the inlet ports of the bubblers so that bubbles occur, after which it flows along with the gaseous precursors again into the pipeline 60 passing out via the outlet ports of the bubblers.

The carrier gas and the gaseous precursors flowing along the pipeline 60 from the bubblers 30, 31 are sprayed through the shower heads 53 of the reactor 50. Here, the RF generator 40 is connected to the shower heads 53 so that the reactant gases sprayed through the shower heads 53 are converted into a plasma state. The precursors, which are sprayed through the shower heads 53 of the reactor 50 and converted into a plasma state, are deposited on the substrate 1 placed on the susceptor 51, thus forming a thin film. The gases remaining after the completion of the deposition reaction are discharged to the outside via the exhaust system provided under the reactor.

The pressure of the carrier gas of the reactor 50 is set to 1×10⁻¹ ∼ 100×10⁻¹ Torr to optimize the formation of the thin film, and the temperature of the substrate 1 is preferably 20 - 50°C. If the temperature of the substrate 1 falls outside of the above range, the deposition rate is lowered. The temperature of the substrate 1 is controlled using a heater embedded in the susceptor. Further, power supplied to the RF generator 40 may be 15 - 80 W. In the case where the magnitude of power is above or below the above range, the formation of the low dielectric constant thin film is hard to achieve. The frequency of plasma thus generated is 10 - 20 MHz. In this way, the pressure of the carrier gas, the temperature of the substrate 1, and the supplying power are set to form the optimal plasma frequency so that the precursors are converted into a plasma state and then deposited on the substrate 1, and may be appropriately adjusted depending on the types of precursors. In the case where hexamethyldisiloxane and 3,3-dimethyl-1-butene are used as the precursors, the above factors are adjusted so that the plasma frequency is about 13.56 MHz.

For a thin film manufactured according to the above mentioned way, an annealing treatment or a plasma treatment may be added.

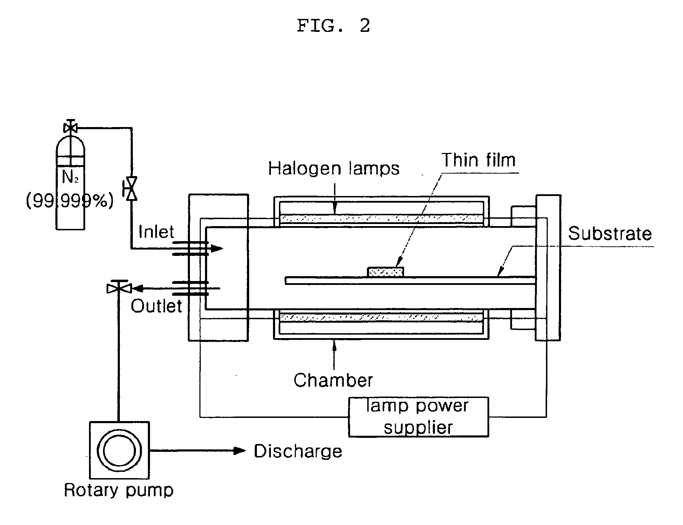

FIG. 2 shows the RTA (rapid thermal annealing) apparatus for performing the annealing process.

The RTA apparatus is used to perform the heat treatment of a specimen, activate electrons in a semiconductor device process, change the properties of an interface between a thin film and a thin film or between a wafer and a thin film, and increase the density of a thin film. Further, this apparatus functions to convert the state of the grown thin film, decrease the loss due to ion implantation, and aid the transport of electrons from a thin film to another thin film or from a thin film to a wafer. Such RTA is carried out using heated halogen lamps and hot chucks. The RTA process may be conducted for a process time shorter than when using a furnace, and is thus referred to as RTP (Rapid Thermal Process). Using such a heat treatment apparatus, the plasma deposited thin film is annealed.

The substrate 1 having the thin film deposited thereon is placed in a chamber of the RTA apparatus, and heat is generated while orange light is emitted, using a plurality of halogen lamps (wavelength: about 2 µm) disposed around the chamber. The RTA process is preferably performed by annealing the substrate having the plasma deposited thin film placed thereon at 300 ∼ 600°C. If the annealing temperature is lower than 300°C, the properties of the initially deposited thin film are not changed. Conversely, if the annealing temperature is higher than 600°C, the structure of the thin film may be undesirably converted from the low dielectric constant thin film into an SiO₂ thin film. Preferably, thus, the treatment temperature is increased to the above annealing temperature within 5 min and then annealing is performed for 1 - 5 min in order to effectively change the structure of the thin film. The RTA is performed at a pressure of 1×10⁻¹ ∼ 100×10⁻¹ Torr in nitrogen gas.

In order to evaluate the properties of the plasma polymerized thin film and the plasma polymerized thin film annealed and/or plasma treated additionally, the following examples are conducted, which are set forth to illustrate, but is not to be construed to limit the present invention.

### EXAMPLES

### Example 1

Using a PECVD apparatus as seen in FIG. 1, precursors, for example, hexamethyldisiloxane (hereinafter referred to as 'HMDSO') and 3,3-dimethyl-1-butene (hereinafter referred to as 'DMB') were respectively loaded into first and second bubblers 30, 31, after which the bubblers were respectively heated to 55°C and 45°C, thus vaporizing the precursor solutions. The gaseous precursors were sprayed along with argon (Ar) gas, having an ultra high purity of 99.999% and acting as a carrier gas, through the shower heads 53 of a reactor 50 for plasma deposition, and were then plasma-deposited on the substrate 1. The pressure of Ar of the reactor 50 was 5×10⁻¹ Torr, and the temperature of the substrate was 35°C. Further, power supplied to the RF generator was 15 - 80W, and the resulting plasma frequency was about 13.56 MHz.

The plasma polymerized thin film thus deposited is referred to as 'HMDSO: DMB'. The thickness of the HMDSO: DMB was measured to be 0.4 - 0.5 µm. The deposition is supposed to occur according to the following mechanism. Specifically, monomers of the precursor mixture transferred into the reactor 50 are activated or decomposed to reactive species by means of plasma and thus condensed on the substrate 1. As such, because the cross-linking between the molecules of HMDSO and DMB is easily formed, the HMDSO:DMB deposited under appropriate conditions is easily crosslinked due to the silicon oxide group and the methyl group of HMDSO and thus has good thermal stability, and also, the polymerization between the methyl group of HMDSO and DMB is seen to efficiently take place.

The HMDSO:DMB thus obtained was annealed using an RTA apparatus illustrated in FIG. 2. The HMDSO:DMB was placed on a substrate 1, and heat was generated by means of 12 halogen lamps (wavelength: about 2 µm) disposed around the substrate, so that the HMDSO:DMB was annealed to 450°C for 5 min in a nitrogen atmosphere. The pressure of nitrogen gas was 1.0 Torr.

The effects of the HMDSO:DMB and the annealed HMDSO:DMB obtained by annealing the HMDSO:DMB using nitrogen were confirmed through the following experiments. In the drawings, 'as-deposited thin film' and '450°C-annealed thin film' are defined as follows.
* As-Deposited Thin Film: initial HMDSO: DMB after the plasma deposition
* 450°C-Annealed Thin Film: annealed HMDSO: DMB obtained by subjecting the initial HMDSO: DMB to RTA using nitrogen gas

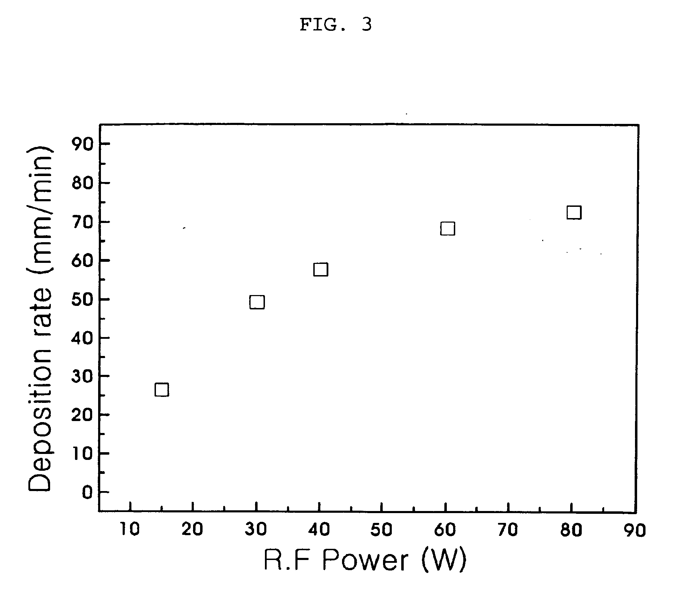

FIG. 3 is a graph showing the deposition rate of the HMDSO: DMB. The deposition rate was seen to be increased in proportion to the increase in power.

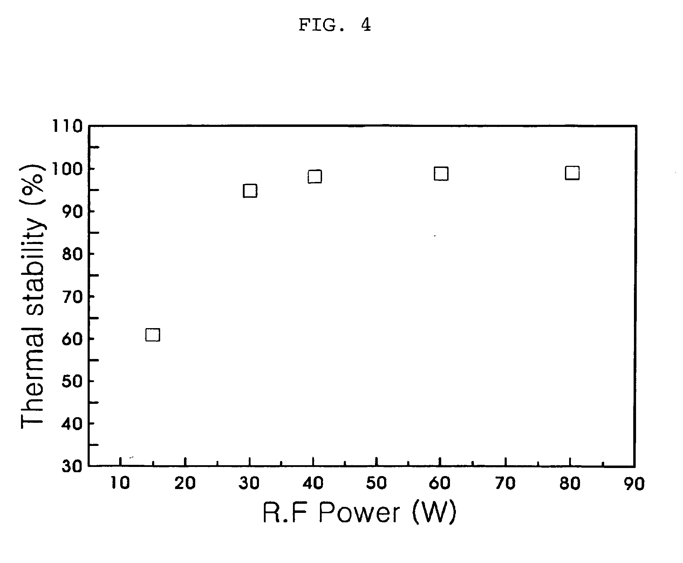

FIG. 4 is a graph showing the thermal stability of the annealed HMDSO: DMB. After performing the annealing process at 450°C for 5 min, the thin film was maintained to the extent of 95% or more. Therefore, the low dielectric constant plasma polymerized thin film according to the present invention could be confirmed to have excellent thermal stability.

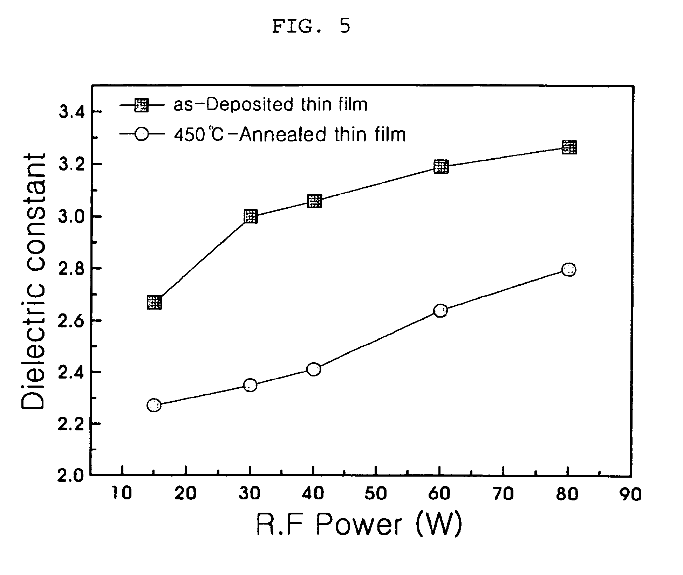

FIG. 5 is a graph showing the relative dielectric constant for the HMDSO: DMB and the annealed HMDSO: DMB. The dielectric constant was measured by applying signals of frequency of 1 MHz to an electric condenser having a structure of Al/HMDSO: DMB /metallic-Si provided on a silicon substrate having very low resistance. As the power was increased, the dielectric constant of the HMDSO: DMB was measured. In this case, the relative dielectric constant of the HMDSO: DMB was increased from 2.67 to 3.27, and the relative dielectric constant of the annealed HMDSO: DMB was increased from 2.27 to 2.8. Thereby, the relative dielectric constant of the RTA-treated thin film was seen to be much lower than the dielectric constant of the plasma deposited thin film.

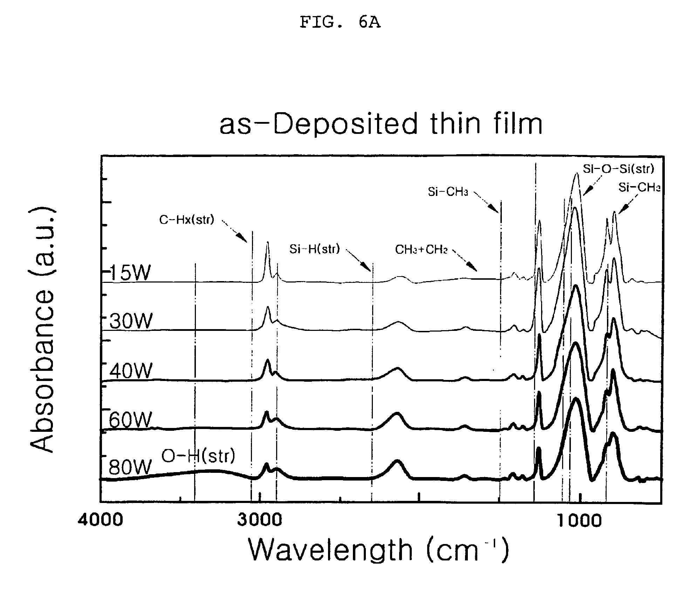

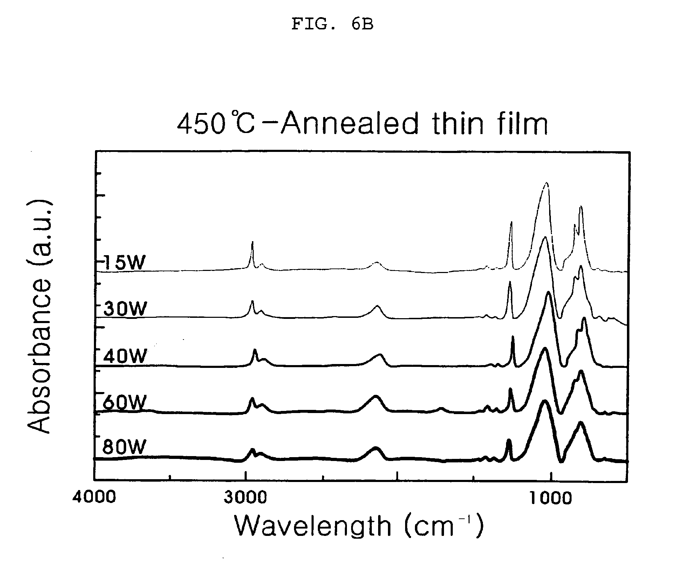

FIGS. 6A and 6B are graphs showing the chemical structures of the HMDSO: DMB and the annealed HMDSO: DMB, respectively, obtained through Fourier transform infrared spectroscopy. As depicted in FIGS. 6A and 6B, in the initial HMDSO: DMB and the annealed HMDSO: DMB, stretching vibrations for the respective chemical structures were generated at the same positions over the entire wavenumber range. Thereby, the HMDSO: DMB and the annealed HMDSO: DMB were confirmed to have similar bonding structures.

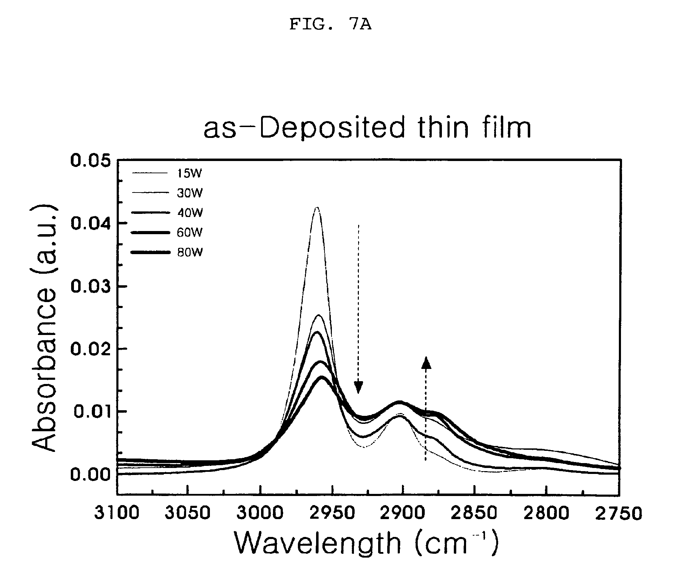

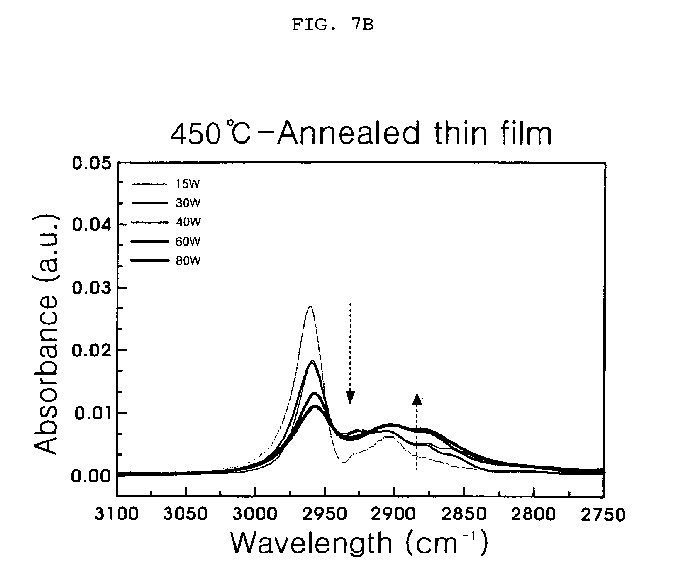

FIGS. 7A and 7B are graphs showing the chemical structures of hydrocarbon-based bonds of the HMDSO: DMB and the annealed HMDSO: DMB, respectively, obtained through Fourier transform infrared spectroscopy.

These graphs show the normalized absorbance of hydrocarbons (CHₓ) corresponding to the organic material among the absorbance values over the entire wavenumber range. As seen in FIG. 7A, the absorbance of the HMDSO: DMB was gradually decreased in inverse proportion to the increase in power, and as seen in FIG. 7B, the absorbance of the annealed HMDSO: DMB was wholly decreased as compared to before the annealing process.

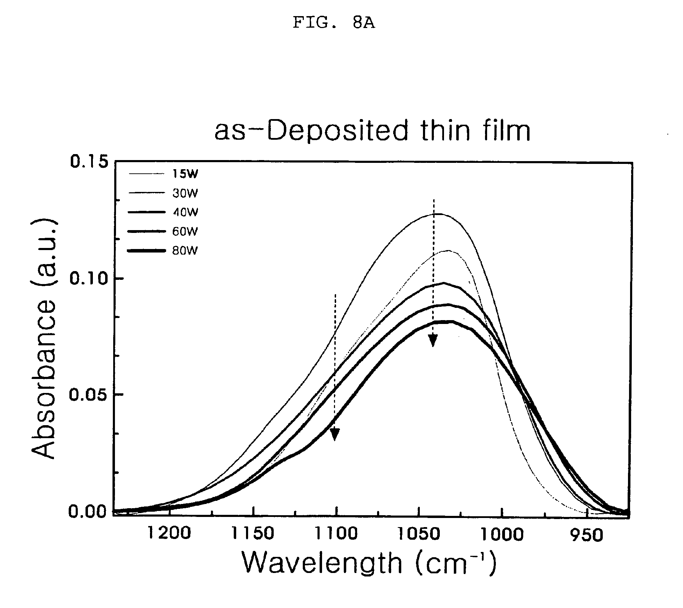

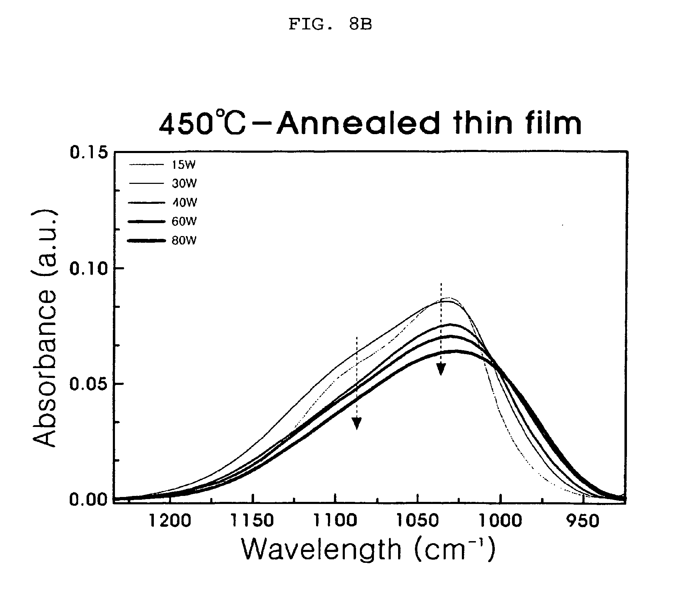

FIGS. 8A and 8B are graphs showing the chemical structures of silicon-oxygen-based bonds of the HMDSO: DMB and the annealed HMDSO: DMB, respectively, obtained through Fourier transform infrared spectroscopy.

As is apparent from the graphs showing the chemical bonds of silicon-oxygen-carbon (Si-O-C) and silicon-oxygen-silicon (Si-O-Si), the proportion of the silicon-based bonding which is a basic structure of the HMDSO:DMB was reduced after the annealing process.

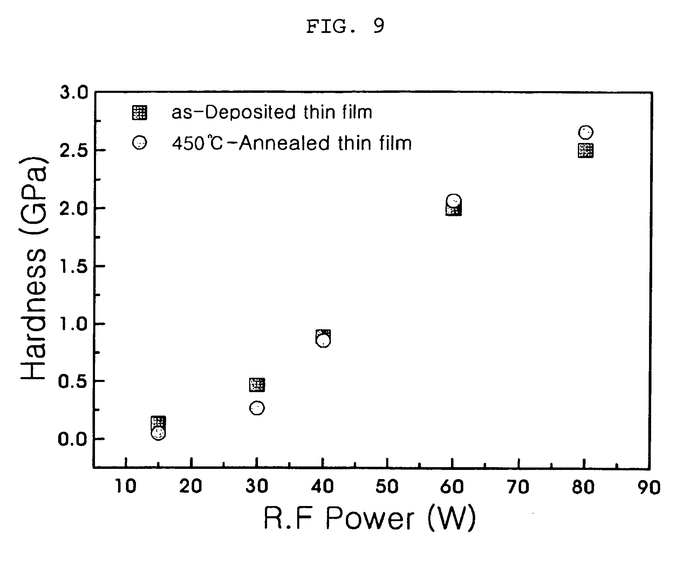

FIG. 9 is a graph showing the hardness of the HMDSO: DMB and the annealed HMDSO: DMB, as measured using a nano-indentor. When the power was increased, the hardness of the HMDSO: DMB was increased from 0.13 GPa to 2.50 GPa, and the hardness of the annealed HMDSO: DMB was increased from 0.05 GPa to 2.66 GPa.

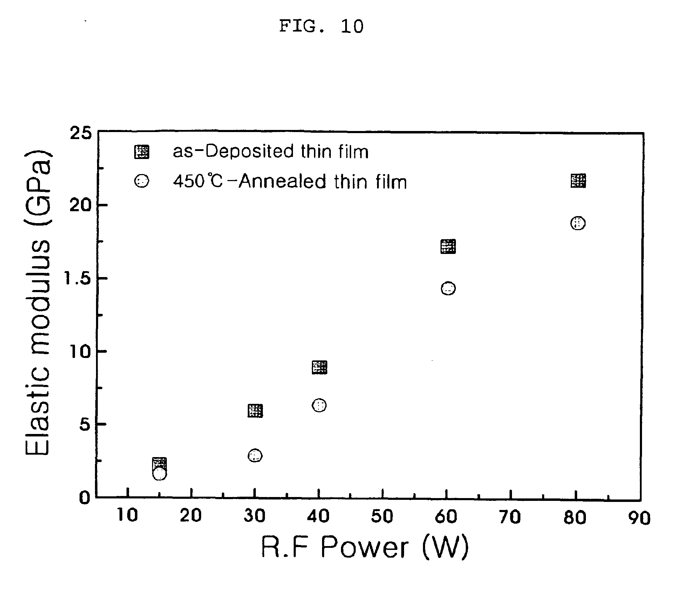

FIG. 10 is a graph showing the elastic modulus of the HMDSO: DMB and the annealed HMDSO: DMB. When the power was increased, the elastic modulus of the HMDSO: DMB was increased from 2.25 GPa to 21.81 GPa, and the elastic modulus of the annealed HMDSO: DMB was increased from 1.66 GPa to 18.9 GPa; the elastic modulus of the annealed thin film was lower than that of the plasma-deposited thin film.

### Example 2

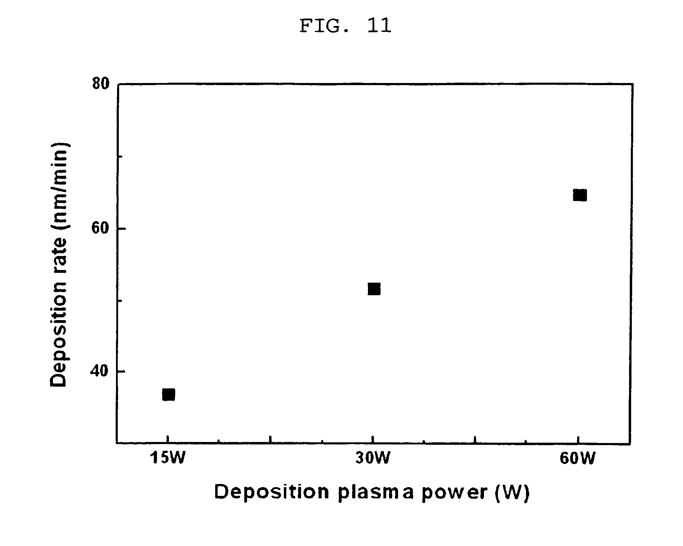

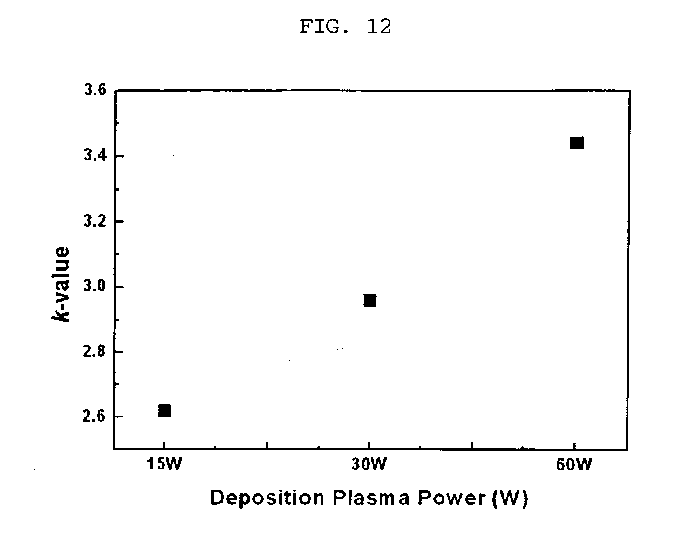

Example 2 was conducted in the same manner as in Example 1 except that the HMDSO and allyloxytrimethylsilane (hereinafter referred to as 'AOTMS') were used as precursors and the HMDSO and the AOTMS were respectively loaded into first and second bubblers, after which the bubblers were respectively heated to 45°C and 80°C. The plasma polymerized thin film thus deposited is referred to as 'HMDSO: AOTMS'. FIG.11 is a graph showing the deposition rate of the HMDSO:AOTMS in accordance with the deposition plasma power. It is noted that the deposition rate was increased from 36 nm/min to 64 nm/min in proportion to the increase in power from 15W to 60W. FIG. 12 is a graph showing the dielectric constant of the HMDSO:AOTMS in accordance with the deposition plasma power of the thin film. It is noted that the dielectric constant of the HMDSO: AOTMS was increased from 2.6 to 3.4 when the deposition plasma power was increased from 15W to 60W.

### Example 3

A plasma treatment was carried out on the plasma polymerized thin film deposited according to Example 1 for the additional plasma treatment by using a mixture gas of H₂ 10 volume% and He 90 volume%(H2/He) as the carrier gas. In the plasma treatment, power supplied to the RF generator was 50W, the pressure of the mixture gas of H₂ and He of the reactor was 20 mTorr, and the plasma treatment time was determined as 1, 2, 10, 15 and 30 minutes.

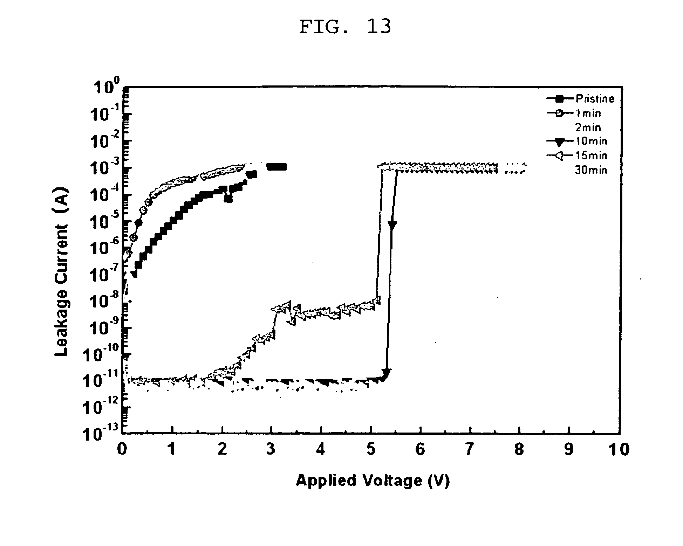

FIG. 13 is a graph showing I(current)-V(voltage) of the HMDSO:DMB formed according to Example 3 in accordance with plasma treatment time. There were no specific differences between the HMDSO:DMB of Example 3 and the pristine thin film which underwent no additional H2/He treatment, when the H₂/He plasma treatment was carried within 10 minutes. However, when the H₂/He plasma treatment was carried for 10 or more minutes (for examples, 15 and 30 minutes), a breakdown voltage was increased and the leakage current was improved, to thereby improve the insulating property.

### Example 4

Example 4 was conducted in the same manner as in Example 3 except that He gas was used as the carrier gas for the additional plasma treatment on the plasma polymerized thin film deposited according to Example 1.

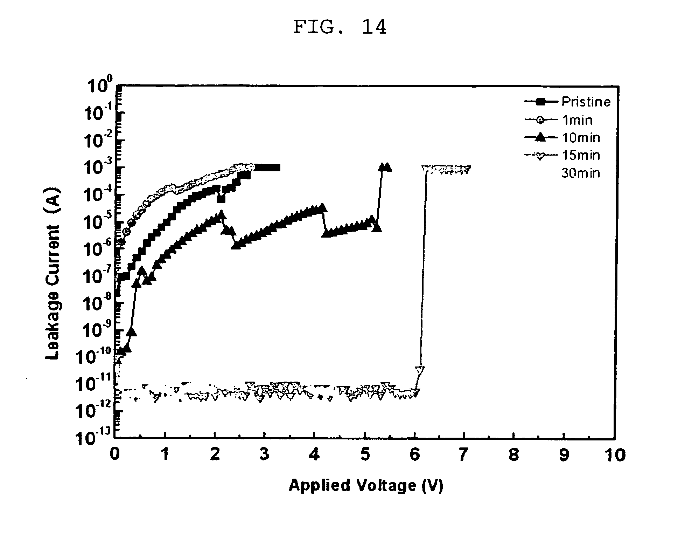

FIG. 14 is a graph showing I(current)-V(voltage) of the HMDSO:DMB according to Example 4 in accordance with time. There were no specific differences between the HMDSO:DMB of Example 4 and the pristine thin film which underwent no additional He treatment, when the He plasma treatment was carried within 10 minutes. However, when the He plasma treatment was carried 10 or more minutes (for examples, 15 and 30 minutes), a breakdown voltage was increased and the leakage current was improved, to thereby improve the insulating property.

As shown in FIG. 13 and FIG.14, I-V properties of both thin films treated by H2/He and He plasma were improved without decreasing the thin films thickness.

Therefore, the plasma polymerized thin film according to the present invention can be seen to be superior in terms of dielectric properties, uniform thin-film thickness, thermal stability, uniform chemical bonding structure, hardness, elastic modulus and insulating property.

As described hereinbefore, the present invention provides a low dielectric constant plasma polymerized thin film and a method of manufacturing the same. According to the present invention, the low dielectric constant thin film having a considerably low dielectric constant can be manufactured using linear organic/inorganic precursors, and further, a complicated process for pretreatment and post-treatment arising in the case of a spin casting process can be reduced. Furthermore, because annealing using an RTA apparatus is conducted, the dielectric constant and mechanical properties of the plasma polymerized thin film can be improved.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A method of manufacturing a low dielectric constant plasma polymerized thin film, comprising:
depositing a plasma polymerized thin film on a substrate using precursors consisting of a compound represented by Formula 1 and a compound represented by Formula 2 below through a plasma enhanced chemical vapor deposition process; and
annealing the deposited thin film using an RTA apparatus: 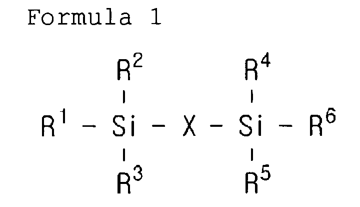 wherein R¹ to R⁶ are each independently selected from the group consisting of a hydrogen atom and substituted or unsubstituted C₁₋₅ alkyl groups, and X is an oxygen atom; and 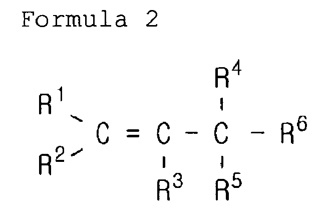 wherein R¹ to R⁵ are each independently selected from the group consisting of a hydrogen atom; and substituted or unsubstituted C_{1∼5} alkyl groups, and R⁶ is selected from the group consisting of a hydrogen atom; and substituted or unsubstituted C_{1∼5} alkyl groups and alkoxysilane groups.

2. The method as set forth in claim 1, wherein R⁶ of Formula 2 represents -O-Si(R⁷)₃; and wherein R⁷ is selected from the group consisting of C_{1∼6} alkyl groups and phenyl groups.

3. The method as set forth in claim 1, wherein the precursor represented by Formula 1 is hexamethyldisiloxane.

4. The method as set forth in claim 1, wherein the precursor represented by Formula 2 is 3,3-dimethyl-1-butene or allyloxytrimethylsilane.

5. The method as set forth in claim 1, wherein the depositing the plasma polymerized thin film on the substrate comprises:
vaporizing the precursors consisting of a compound represented by Formula 1 and a compound represented by Formula 2 in bubblers;
supplying the gaseous precursors into a reactor for plasma deposition from the bubblers; and
forming a plasma polymerized thin film on the substrate in the reactor using plasma of the reactor.

6. The method as set forth in claim 5, wherein the step of supplying the gaseous precursors into a reactor for plasma deposition from the bubblers comprises a carrier gas of the reactor, and the carrier gas is argon(Ar) or helium(He); and wherein a pressure of the carrier gas is 1×10⁻¹ ∼ 100×10⁻¹ Torr.

7. The method as set forth in claim 5, further comprising an annealing treatment or a plasma treatment on the plasma polymerized thin film after the forming a plasma polymerized thin film on the substrate in the reactor.

8. The method as set forth in claim 7, wherein the carrier gas, as a plasma gas, in the plasma treatment, is selected from the group consisting of argon(Ar), helium (He) and a mixture gas of hydrogen and helium; and a pressure of the carrier gas is 1×10⁻³ ∼ 1×10⁻¹ Torr.

9. The method as set forth in claim 8, the mixture gas of hydrogen and helium consists of about 5 to 15 volume% of hydrogen gas and about 95 to 85 volume% of helium gas.

10. The method as set forth in claim 5, wherein a temperature of the substrate in the reactor is about 20 ∼ 50°C.

11. The method as set forth in claim 5, wherein power supplied to the reactor is about 15 - 80 W.

12. The method as set forth in claim 1, wherein the step of annealing the deposited thin film using the RTA apparatus is conducted by placing the substrate having the plasma polymerized thin film deposited thereon in a chamber of the RTA apparatus, and generating heat on the substrate using a plurality of halogen lamps disposed around the chamber.

13. The method as set forth in claim 1, wherein the step of annealing the deposited thin film using the RTA apparatus is conducted in nitrogen gas.

14. The method as set forth in claim 1, wherein the step of annealing the deposited thin film using the RTA apparatus is conducted by increasing the temperature of the substrate to about 300 - 600°C and then performing annealing.

15. The method as set forth in claim 1, wherein the step of annealing the deposited thin film using the RTA apparatus is conducted by increasing the temperature of the substrate to about 300 - 600°C within 5 min and then performing annealing.

16. The method as set forth in claim 1, wherein the step of annealing the deposited thin film using the RTA apparatus is conducted by annealing the substrate for about 1- 5 min.

17. The method as set forth in claim 1, wherein the step of annealing the deposited thin film using the RTA apparatus is conducted at a pressure of about 0.5 - 1.5 Torr.

## Patentansprüche

1. Verfahren zum Herstellen einer mittels Plasma polymerisierten Dünnschicht mit niedriger Dielektrizitätskonstante, das Folgendes umfasst:
Ablagern einer mittels Plasma polymerisierten Dünnschicht auf einem Substrat unter Verwendung von Vorläufern, die aus einer Verbindung, die durch die Formel 1 repräsentiert wird, und aus einer Verbindung, die durch die Formel 2 unten repräsentiert wird, bestehen, mittels eines plasmaverstärkten Prozesses chmischen Gasphasenabscheidung; und
Glühen der abgelagerten Dünnschicht unter Verwendung einer RTA-Vorrichtung: 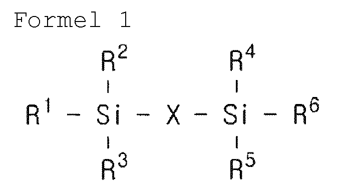 wobei R¹ bis R⁶ jeweils unabhängig aus der Gruppe gewählt sind, die aus einem Wasserstoffatom und aus substituierten oder nicht substituierten C₁₋₅-Alkylgruppen besteht, und wobei X ein Sauerstoffatom ist; und 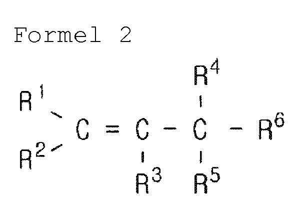 wobei R¹ bis R⁵ jeweils unabhängig aus der Gruppe gewählt sind, die aus einem Wasserstoffatom; und substituierten oder nicht substituierten C₁₋₅-Alkylgruppen besteht, und R⁶ aus der Gruppe gewählt ist, die aus einem Wasserstoffatom; und aus substituierten oder nicht substituierten C₁₋₅-Alkylgruppen und Alkoxysilan-Gruppen besteht.

2. Verfahren nach Anspruch 1, wobei R⁶ von Formel 2 -O-Si(R⁷)₃ repräsentiert; und wobei R⁷ aus der Gruppe ausgewählt ist, die aus C₁₋₆-Alkylgruppen und PhenylGruppen besteht.

3. Verfahren nach Anspruch 1, wobei der Vorläufer, der durch die Formel 1 repräsentiert wird, Hexamethyldisiloxan ist.

4. Verfahren nach Anspruch 1, wobei der Vorläufer, der durch die Formel 2 repräsentiert wird, 3,3-Dimethyl-1-Buten oder Allyloxytrimethylsilan ist.

5. Verfahren nach Anspruch 1, wobei das Ablagern der mittels Plasma polymerisierten Dünnschicht auf dem Substrat Folgendes umfasst:
Verdampfen der Vorläufer, die aus einer Verbindung, die durch die Formel 1 repräsentiert wird, und aus einer Verbindung, die durch die Formel 2 repräsentiert wird, bestehen, in Gasspülern;
Liefern der gasförmigen Vorläufer aus den Gasspülern zu einem Reaktor für die Plasmaablagerung; und
Bilden einer mittels Plasma polymerisierten Dünnschicht auf dem Substrat in dem Reaktor unter Verwendung von Plasma des Reaktors.

6. Verfahren nach Anspruch 5, wobei der Schritt der Zufuhr der gasförmigen Vorläufer aus den Gasspülern zu einem Reaktor für die Plasmaablagerung ein Trägergas des Reaktors umfasst, wobei das Trägergas Argon (Ar) oder Helium (He) ist; und wobei ein Druck des Trägergases im Bereich von 1 · 10⁻¹ bis 100 · 10⁻¹ Torr ist.

7. Verfahren nach Anspruch 5, das ferner eine Glühbehandlung oder eine Plasmabehandlung an der mittels Plasma polymerisierten Dünnschicht umfasst, nachdem eine mittels Plasma polymerisierte Dünnschicht auf dem Substrat in dem Reaktor erzeugt worden ist.

8. Verfahren nach Anspruch 7, wobei das Trägergas als ein Plasmagas in der Plasmabehandlung aus der Gruppe gewählt wird, die aus Argon (Ar), Helium (He) und einem Mischgas aus Wasserstoff und Helium besteht; und ein Druck des Trägergases im Bereich von 1 · 10⁻³ bis 1 · 10⁻¹ Torr ist.

9. Verfahren nach Anspruch 8, wobei das Mischgas aus Wasserstoff und Helium aus etwa 5 bis 15 Vol.-% Wasserstoffgas und aus etwa 95 bis 85 Vol.-% Heliumgas besteht.

10. Verfahren nach Anspruch 5, wobei eine Temperatur des Substrats im Reaktor etwa 20 bis 50 °C beträgt.

11. Verfahren nach Anspruch 5, wobei die dem Reaktor zugeführte Leistung etwa 15 bis 80 W beträgt.

12. Verfahren nach Anspruch 1, wobei der Schritt des Glühens der abgelagerten Dünnschicht unter Verwendung der RTA-Vorrichtung durch Anordnen des Substrats, auf dem die mittels Plasma polymerisierte Dünnschicht abgelagert ist, in einer Kammer der RTA-Vorrichtung und durch Erzeugen von Wärme auf dem Substrat unter Verwendung mehrerer um die Kammer angeordneter Halogenlampen ausgeführt wird.

13. Verfahren nach Anspruch 1, wobei der Schritt des Glühens der abgelagerten Dünnschicht unter Verwendung der RTA-Vorrichtung in Stickstoffgas ausgeführt wird.

14. Verfahren nach Anspruch 1, wobei der Schritt des Glühens der abgelagerten Dünnschicht unter Verwendung der RTA-Vorrichtung durch Erhöhen der Temperatur des Substrats auf etwa 300 bis 600 °C und dann durch Ausführen des Glühens ausgeführt wird.

15. Verfahren nach Anspruch 1, wobei der Schritt des Glühens der abgelagerten Dünnschicht unter Verwendung der RTA-Vorrichtung durch Erhöhen der Temperatur des Substrats auf etwa 300 bis 600 °C innerhalb von 5 Minuten und dann durch Ausführen eines Glühens ausgeführt wird.

16. Verfahren nach Anspruch 1, wobei der Schritt des Glühens der abgelagerten Dünnschicht unter Verwendung der RTA-Vorrichtung durch Glühen des Substrats für etwa 1 bis 5 Minuten ausgeführt wird.

17. Verfahren nach Anspruch 1, wobei der Schritt des Glühens der abgelagerten Dünnschicht unter Verwendung der RTA-Vorrichtung bei einem Druck im Bereich von etwa 0,5 bis 1,5 Torr ausgeführt wird.

## Revendications

1. Procédé de fabrication d'un film mince polymérisé au plasma à faible constante diélectrique, comprenant :
le dépôt d'un film mince polymérisé au plasma sur un substrat à l'aide de précurseurs constitués d'un composé représenté par la formule 1 et d'un composé représenté par la formule 2 ci-dessous par un procédé de dépôt chimique en phase vapeur renforcé au plasma ; et
le recuit du film mince déposé à l'aide d'un appareil de recuit thermique rapide (RTA) : 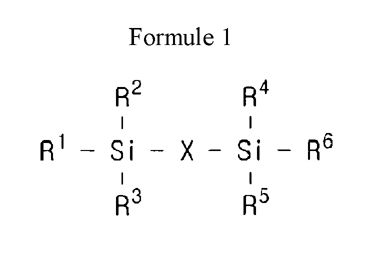 dans laquelle R¹ à R⁶ sont chacun indépendamment choisis dans le groupe constitué d'un atome d'hydrogène et de groupes alkyle en C₁-C₅ substitués ou non substitués, et X est un atome d'oxygène ; et 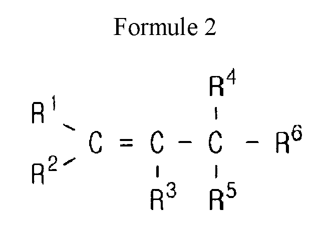 dans laquelle R¹ à R⁵ sont chacun indépendamment choisis dans le groupe constitué d'un atome d'hydrogène ; et de groupes alkyle en C₁-C₅ substitués ou non substitués, et R⁶ est choisi dans le groupe constitué d'un atome d'hydrogène ; de groupes alkyle en C₁-C₅ substitués ou non substitués et de groupes alcoxysilane.

2. Procédé selon la revendication 1, dans lequel R⁶ de la formule 2 représente -O-Si(R⁷)₃ ; et dans lequel R⁷ est choisi dans le groupe constitué de groupes alkyle en C₁-C₆ et de groupes phényle.

3. Procédé selon la revendication 1, dans lequel le précurseur représenté par la formule 1 est l'hexaméthyldisiloxane.

4. Procédé selon la revendication 1, dans lequel le précurseur représenté par la formule 2 est le 3,3-diméthyl-1-butène ou l'allyloxytriméthylsilane.

5. Procédé selon la revendication 1, dans lequel le dépôt du film mince polymérisé au plasma sur le substrat comprend :
la vaporisation des précurseurs constitués d'un composé représenté par la formule 1 et d'un composé représenté par la formule 2 dans des barboteurs ;
l'alimentation des précurseurs gazeux dans un réacteur pour le dépôt au plasma à partir des barboteurs ; et
la formation d'un film mince polymérisé au plasma sur le substrat dans le réacteur à l'aide du plasma du réacteur.

6. Procédé selon la revendication 5, dans lequel l'étape d'alimentation des précurseurs gazeux dans un réacteur pour le dépôt au plasma à partir des barboteurs comprend un gaz porteur du réacteur et le gaz porteur est l'argon (Ar) ou l'hélium (He) ; et dans lequel la pression du gaz porteur est de 1 x 10⁻¹ à 100 x 10⁻¹ Torrs.

7. Procédé selon la revendication 5, comprenant en outre un traitement de recuit ou un traitement au plasma sur le film mince polymérisé au plasma après la formation d'un film mince polymérisé au plasma sur le substrat dans le réacteur.

8. Procédé selon la revendication 7, dans lequel le gaz porteur, en tant que gaz du plasma, dans le traitement au plasma, est choisi dans le groupe constitué de l'argon (Ar), de l'hélium (He) et d'un mélange gazeux d'hydrogène et d'hélium ; et la pression du gaz porteur est de 1 x 10⁻³ à 1 x 10⁻¹ Torr.

9. Procédé selon la revendication 8, dans lequel le mélange gazeux d'hydrogène et d'hélium est constitué d'environ 5 à 15 % en volume d'hydrogène gazeux et d'environ 95 à 85 % en volume d'hélium gazeux.

10. Procédé selon la revendication 5, dans lequel la température du substrat dans le réacteur est d'environ 20 à 50°C.

11. Procédé selon la revendication 5, dans lequel la puissance fournie au réacteur est d'environ 15 à 80 W.

12. Procédé selon la revendication 1, dans lequel l'étape de recuit du film mince déposé à l'aide de l'appareil de RTA est réalisé en plaçant le substrat sur lequel est déposé le film mince polymérisé au plasma dans une chambre de l'appareil de RTA et en générant de chaleur sur le substrat à l'aide d'une pluralité de lampes halogène placées autour de la chambre.

13. Procédé selon la revendication 1, dans lequel l'étape de recuit du film mince déposé à l'aide de l'appareil de RTA est réalisé dans de l'azote gazeux.

14. Procédé selon la revendication 1, dans lequel l'étape de recuit du film mince déposé à l'aide de l'appareil de RTA est réalisé en augmentant la température du substrat jusqu'à environ 300 à 600°C et ensuite en réalisant ensuite le recuit.

15. Procédé selon la revendication 1, dans lequel l'étape de recuit du film mince déposé à l'aide de l'appareil de RTA est réalisé en augmentant la température du substrat jusqu'à environ 300 à 600°C en l'espace de 5 min et en réalisant ensuite le recuit.

16. Procédé selon la revendication 1, dans lequel l'étape de recuit du film mince déposé à l'aide de l'appareil de RTA est réalisé en recuisant le substrat pendant d'environ 1 à 5 min.

17. Procédé selon la revendication 1, dans lequel l'étape de recuit du film mince déposé à l'aide de l'appareil de RTA est réalisé sous une pression d'environ 0,5 à 1,5 Torr.
